Europäisches Patentamt

European Patent Office

Office européen des brevets

(11) Publication number: **0 279 993 B1**

(12) **EUROPEAN PATENT SPECIFICATION**

(45) Date of publication of patent specification: **02.09.92**    (51) Int. Cl.⁵: **H03K 4/00**, H03K 17/16

(21) Application number: **87311386.4**

(22) Date of filing: **23.12.87**

Divisional application 91202141.7 filed on 23/12/87.

(54) **A circuit for removing unwanted temporal portions of a voltage varying signal.**

(30) Priority: **27.02.87 US 20289**

(43) Date of publication of application:
**31.08.88 Bulletin 88/35**

(45) Publication of the grant of the patent:
**02.09.92 Bulletin 92/36**

(84) Designated Contracting States:
**DE FR GB**

(56) References cited:
**EP-A- 0 094 314        EP-A- 0 165 553
EP-A- 0 176 596        EP-A- 0 194 641
US-A- 4 238 809        US-A- 4 418 305**

(73) Proprietor: **SEAGATE TECHNOLOGY INTERNA-
TIONAL
c/o Maples & Calder, P.O. Box 309
Georgetown, Grand Cayman Island(KY)**

(72) Inventor: **Janz, Donald Walter
11809 North Woodbridge Road
Oklahoma City, OK 73132(US)**

(74) Representative: **Miller, Joseph et al
J. MILLER & CO. 34 Bedford Row, Holborn
London WC1R 4JH(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to circuits for removing unwanted temporal portions of voltage varying signals and has particular application to deriving such signals for driving servo-mechanisms where the unprocessed signals contain undesirable portions. The present invention is particularly useful for signals in which a desired portion of a signal contains a leg of relatively mild slope and a rapid leg of relatively large opposite slope and has particular application to deriving useful velocity information from "tri-phase servo patterns".

In the prior art, European Application EP-A-0 165 553 discloses a circuit for removing unwanted temporal portions of a voltage signal, without differentiating the signal. However, this circuit requires two switches in order to isolate the holding capacitor from a low impedance input and two different timing signals must be provided for the switches. Moreover, a high impedance device must be attached to the output of the circuit in order to prevent the holding capacitor from discharging.

According to the present invention there is provided a circuit for removing unwanted temporal portions of a voltage varying signal on the occurrence of a reset signal and for differentiating a resultant corrected signal with the respect to a reference voltage, said circuit having switch means responsive to said reset signal applied to a first input; first operational amplifier means having positive and negative inputs and an output connected to a second input of said switch means; second operational amplifier means; storage capacitor means having one side connected to a reference voltage and having its other side in electrical connection to the negative input of the first operational amplifier means and a first output of the switch means, said circuit being characterised by input capacitor means for receiving said input signal, the positive input of the first operational amplifier means being connected to receive a voltage representative of the current through said input capacitor means; by said switch means, in operation, being responsive to said reset signal to direct a second input of the switch means to a second output from a first output and thence to return said second input to said first output; by inverting amplifier means connected to receive the second output of the switch means; and by the second operational amplifier means being arranged so as to receive said corrected signal from the inverting amplifier means and having a negative input which is connected through a first resistor and through the inverting amplifier means to said second output of the switch means, said negative input also being in electrical connection through said first resistor with said input capacitor means and with said positive input of said first operational amplifier means, a positive input connected to a reference voltage, and providing a differentiated corrected signal at its output which is connected via a feedback resistor to said negative input.

Preferably the negative input of said second operational amplifier means is also connected to a reference voltage throught the first resistor and a filter capacitor which is connected between a second resistor and said first resistor, the negative input of said second operational amplifier means being in electrical connection through both said first and second resistors to said input capacitor means, to the output of said inverting amplifier means and to said positive input of said first operational amplifier means.

In one embodiment the negative input of said second operational amplifier means is in electrical connection with its output via said feedback resistor and a compensating capacitor connected in parallel therewith.

A third resistor may be connected between said second resistor and said input capacitor means, said input capacitor means being connected through said third resistor with said inverting amplifier means and with said positive input of the first operational amplifier means.

Said reset signal may be generated from a tri-phase servo signal. Said reset signal preferably is generated from the same tri-phase servo signal which is used to generate said input signal.

In one embodiment a storage resistor is connected in series between said storage capacitor means and said negative input of said first operational amplifier means. One side of the storage resistor may be connected to said first output of the switch means and said negative input of the first operational amplifier means and the other side is connected to said storage capacitor means.

The invention is illustrated, merely by way of example, in the accompanying drawings, in which:-

Figure 1 is a simplified diagram of one embodiment of a circuit according to the present invention for removing unwanted temporal portions of a voltage varying signal;

Figure 1A is a detailed diagram of the circuit of Figure 1;

Figure 2 is a graph with a set of voltage signals with respect to time to illustrate the operation of the circuit of Figure 1;

Figure 3 is a diagram of a typical practical differentiator;

Figure 4 is graph of a non-ideal input signal to the circuit of Figure 1;

Figure 5 is a graph of a possible ideal output signal from the circuit of Figure 1;

Figure 6 is a diagram of a circuit for deriving a reset signal from the tri-phase servo pattern for the circuit of Figure 1;

Figure 7 is a graph of three signals, pairs of which are related to the circuit of Figure 6;

Figure 8 is a graph of an output signal of the circuit of Figure 6;

Figure 9 is a schematic diagram of a circuit for deriving a reset signal for the circuit of Figure 1; and

Figure 10 is a timing diagram for use with Figure 9.

Throughout the drawings like parts have been designated by the same reference numerals.

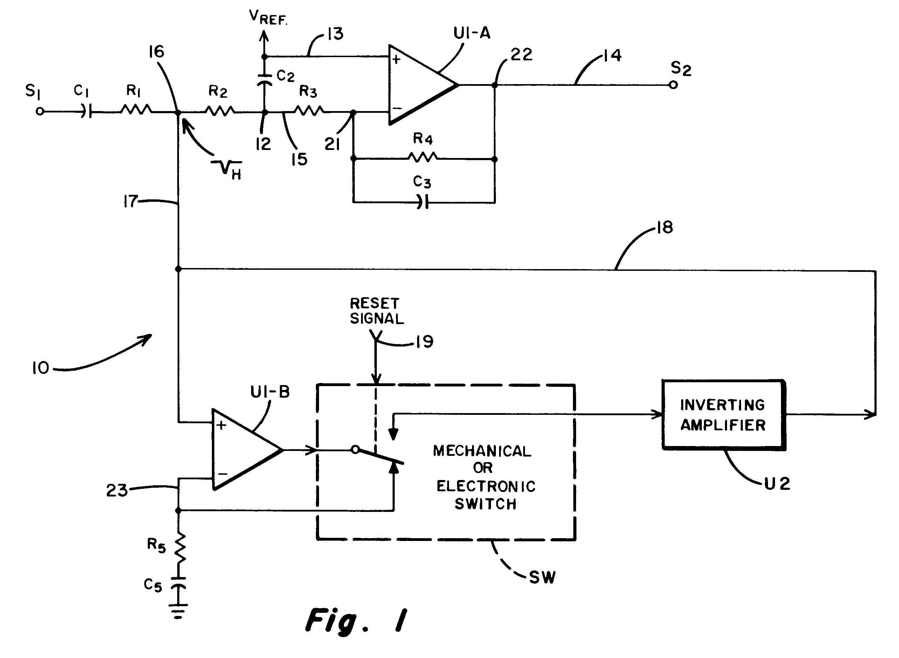

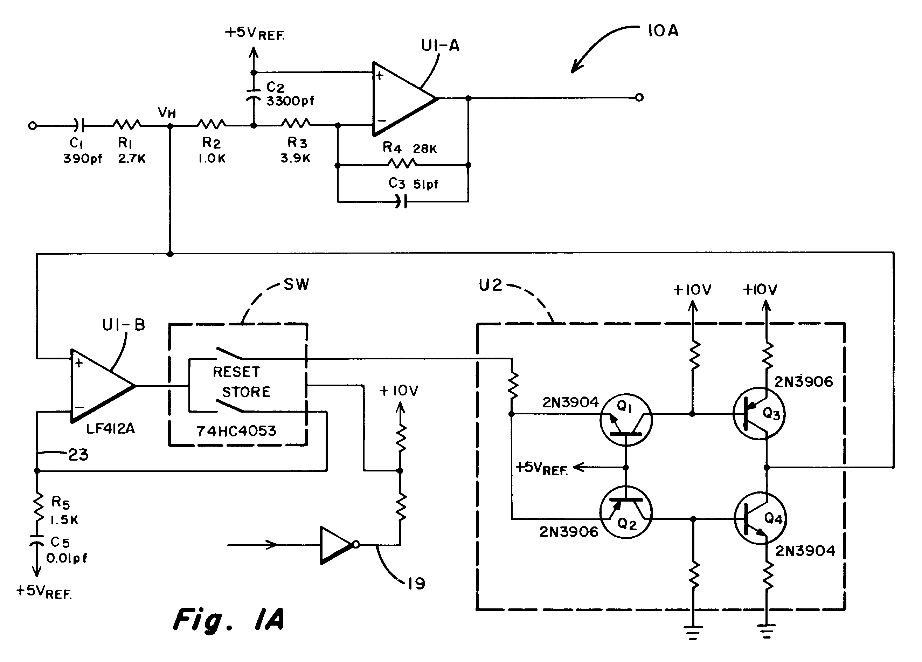

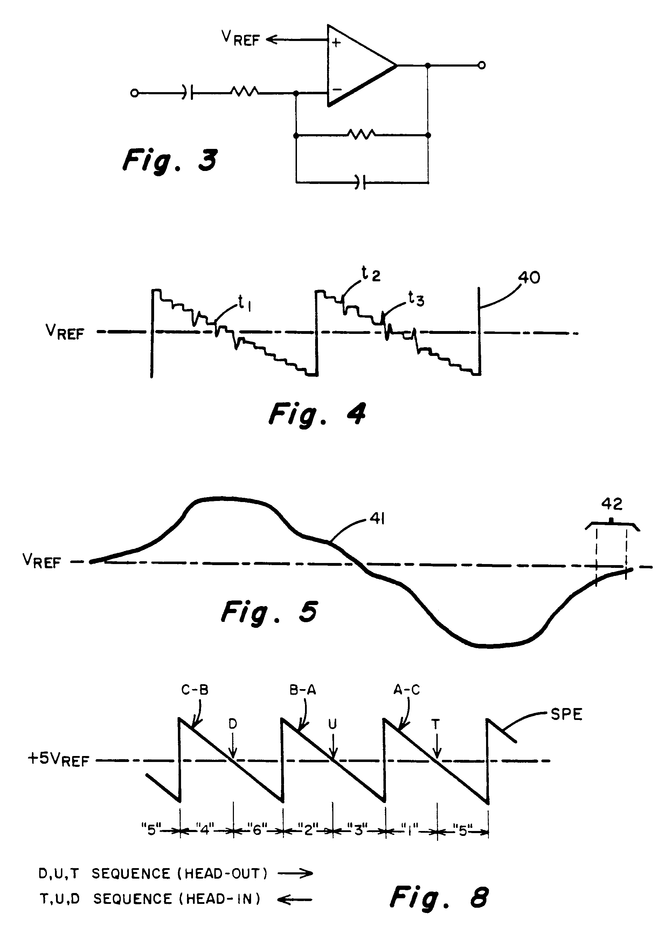

Figure 1 is a simplified diagram of a circuit 10 according to the present invention for removing unwanted temporal portions of a voltage varying signal. The term "line" used herein is to denote electrical connection via wire or other means. An input signal is provided to the circuit 10 at a point S1 charging a capacitor C1 and thence through resistors R1,R2,R3 to a negative input of an operational amplifier U1-A. The line between the resistor R3 and the negative input to the operational amplifier U1-A is also linked to a resistor R4 and a capacitor C3 which are connected in parallel between a point 21 and a point 22, on a line 14. Thus the combination of the operational amplifier U1-A, the resistor R4 and the capacitor C3 constitutes a differentiator as shown in Figure 3. The line 14 is the output of the operational amplifier U1-A provided as output from the circuit 10 at a point S2. A positive input line 13 to the operational amplifier U1-A provides a reference voltage and is connected across a capacitor C2 to a point 12 on a signal input line 15. Between resistors R1,R2 on the signal input line, a point 16 connects a line 17 to the positive input of an operational amplifier U1-B. The line 17 is also connected to a line 18. The negative input of the operational amplifier U1-B is connected to ground (GND) through a resistor R5 and a capacitor C5 on a line 23. The output of the operational amplifier U1-B is selectively connected between: (a) a point on the line 23 between the negative input to the operational amplifier U1-B and the resistor R5, and (b) an approximate minus one or inverting amplifier U2. The selection is governed by a reset signal provided on a line 19 to a mechanical or electronic switch SW. On the occurrence of a reset signal on the line 19, the switch SW directs the output of the operational amplifier U1-B to the amplifier U2. After the reset signal indicates that the reset is no long occurring, the switch is set to provide the output of the operational amplifier U1-B to the line 23. The output of the amplifier U2 is provided on the line 18 to its connection to the line 17.

The input signal charges the capacitor C1 and provides a voltage level $V_H$ at a point 16 which represents the charging current through the capacitor C1. Referring briefly to Figure 3, it will be noted that the resistors R2,R3 and the capacitor C2 are additions to this circuit which are not found in a typical practical differentiator of Figure 3.

Note that the operational amplifier U1-A connected as shown will tend to stabilise itself at a point where the voltage on the negative input is brought up to a voltage level $V_{REF}$ on the positive input. Therefore, the output voltage of the operational amplifier U1-A will tend to be proportional to the voltage level $V_H$. It should be recognised that because the changes in the voltage level $V_H$ may be very small (about 0.1 millivolt) any ambient current leakage will affect the circuit performance This fact must be considered in component choice.

The voltage level $V_H$ on the line 17 is provided as a positive input to the operational amplifier U1-B. During normal operation of the circuit 10 when the wanted portion of the signal is provided as the input signal to the point S1 and no reset signal is present on the line 19, the output of the operational amplifier U1-B is provided to the line 23 as input to the negative input of the operational amplifier U1-B and through the resistor R5 to the capacitor C5 and to ground, or as in a preferred embodiment, may employ a 5 volt reference in place of ground. The resistor R5 can provide filtering to the voltage provided to the capacitor C5 if desired. On the occurrence of a reset signal, the switch SW transfers the output of the operational amplifier U1-B to the amplifier U2. Thus the voltage level on the capacitor C5 provides an error voltage to the amplifier U2 which provides a voltage level equal to the voltage level on the capacitor C5 on the line 18 to the line 17 and to the point 16, thus sustaining the voltage level to the negative input of the operational amplifier U1-A during the reset interval.

A more detailed schematic diagram of the circuit of Figure 1 is provided in Figure 1A in which the resistance and capacitance values are provided and reference made to standard industrial use numbers for designating particular integrated circuit and other component parts.

Referring now to Figure 1A the circuit is indicated by reference numeral 10A. Resistance, capacitance, and voltage values may be varied in accordance with known principles. Certain characteristics of some of the component parts shown, however, are important to prevent problems with ambient voltage affecting the performance of the differentiation characteristics of the operational amplifier U1-A. For instance, the amplifier U2 comprises a low leakage, high output impedance inverter amplifier when not operating so transistors Q3,Q4, for instance, must be low leakage transistors. The numbers 2N3906 and 2N3904 designates transistors of this type. Transistors Q1 and Q2 need not be low leakage transistors. Likewise, the operational amplifier U1-B, designated by the industry standard number LF412A (currently available through National Semiconductor Corporation) is a high speed operational amplifier with high input impedance (100 pico amp input), which will have no leakage current to affect the operation of the operational amplifier U1-A, which most likely will be on the same circuit board.

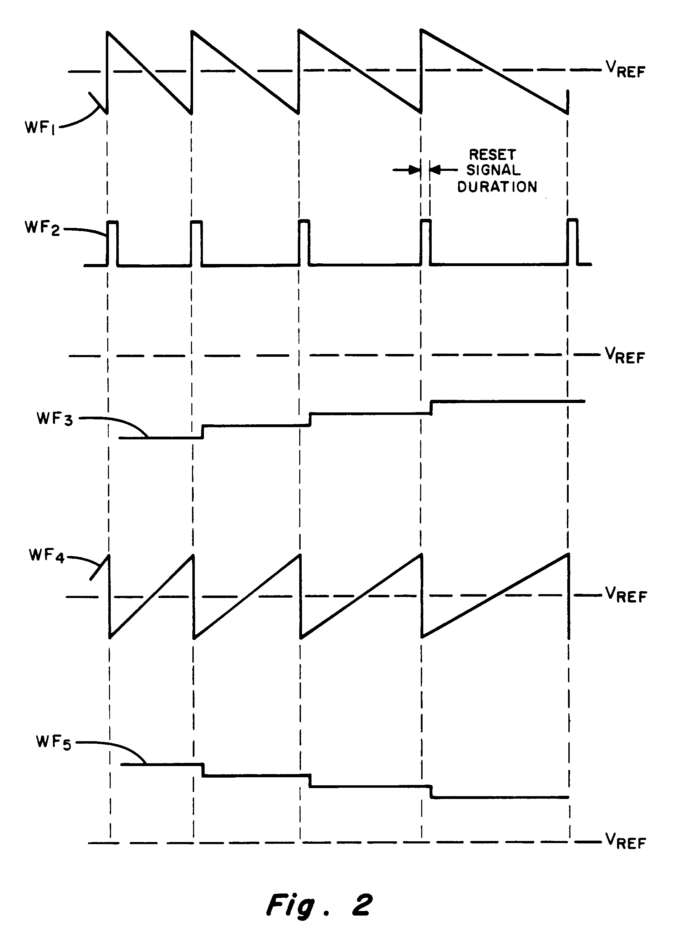

Figure 4 illustrates a small segment of a possible non-ideal input signal 40. This signal will correspond to some portion of a signal $WF_1$ whose waveform is shown in Figure 2. Because this signal is originally generated by digital circuits, it takes on a stairstep form as shown. Due probably primarily to irregularities on the data disk itself, transients or spikes $t_1, t_2, t_3$ will often be found in the non-ideal input signal. These transients, as well as the stairstep configuration of the input signal 40, will be smoothed and filtered out by the circuit of Figure 1. The input signal 40 is indicated with reference to the voltage level $V_{REF}$ in Figure 4.

It must be noted that the reference voltage levels need not be the same DC potential for any of the three points to which they are introduced into the circuit but the potential values must be constant. A reference voltage level of 5 volts for the positive input of the operational amplifier was found to be best in practice to achieve the greatest dynamic range for the power supplies used.

Figure 5 describes by a curve 41 a possible ideal output signal. Segment 42 corresponds to a negative output signal portion indicated by signal $WF_3$ in Figure 2.

There are five waveforms illustrated in Figure 2, namely:

$WF_1$, an input signal with a negative going slope with a positive slope transition;

$WF_2$, a reset signal consisting of a series of pulses indicating the time period for the slope transition;

$WF_3$, a negative output signal provided at the point S2 for the input signal $WF_1$;

$WF_4$, an input signal of positive slope and its corresponding output for a positive output $WF_5$.

All these waveform signals occur over the same length of time and the voltage value is plotted against the voltage reference level $V_{REF}$. Signals $WF_1, WF_2, WF_3$ may occur concurrently, and signals $WF_4, WF_5, WF_2$ may also occur concurrently, using a circuit according to the present invention.

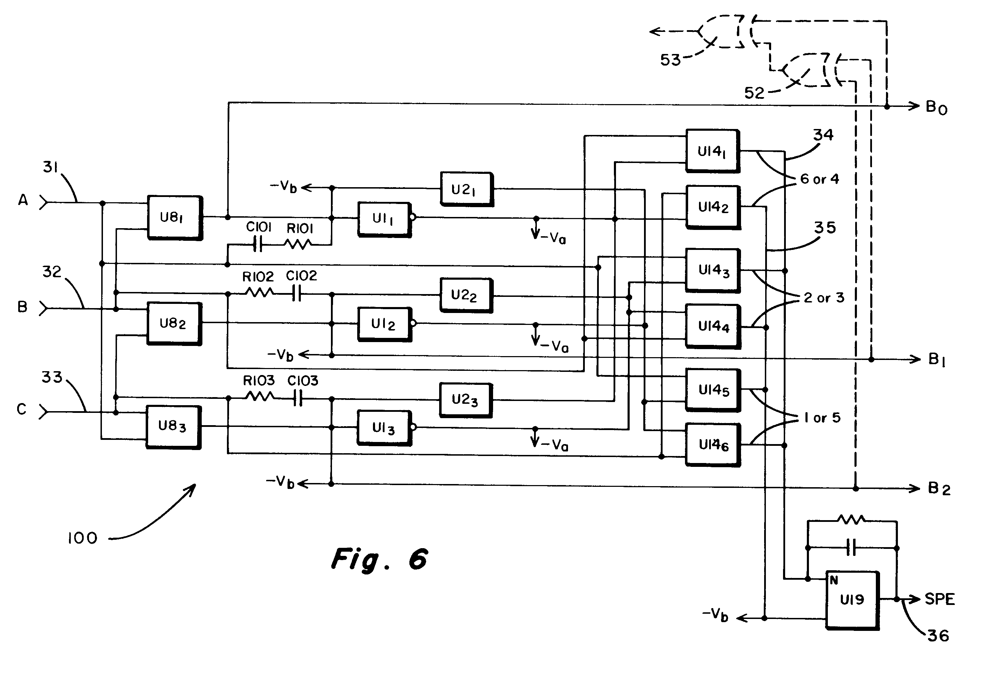

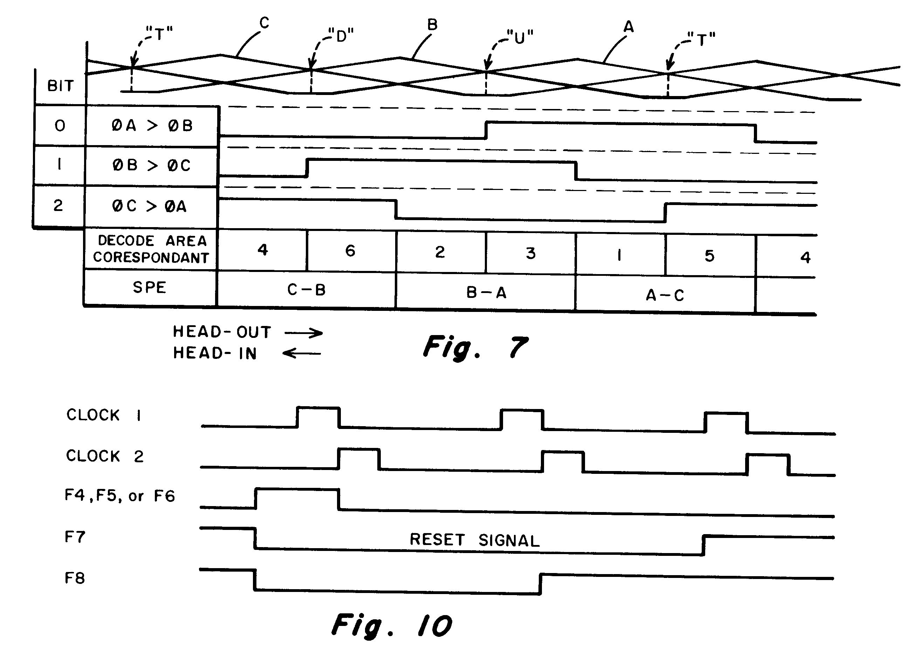

Referring now to Figure 6 there is shown a circuit diagram of a circuit 100 through which the reset signal may be derived from tri-phase signals. Three triangle wave signals A,B,C are provided on lines 31,32,33, respectively. The triangle waves are derived from tri-phase spaced signals located in a formatted data disk. The circuit 100 of Figure 6 provides an output signal from line 36 which forms the signal input at the point S1 of the circuit 10 of Figures 1 and 1A. A detailed representation of this output signal is found in Figure 8 and of the signals A,B,C is found at the top of Figure 7.

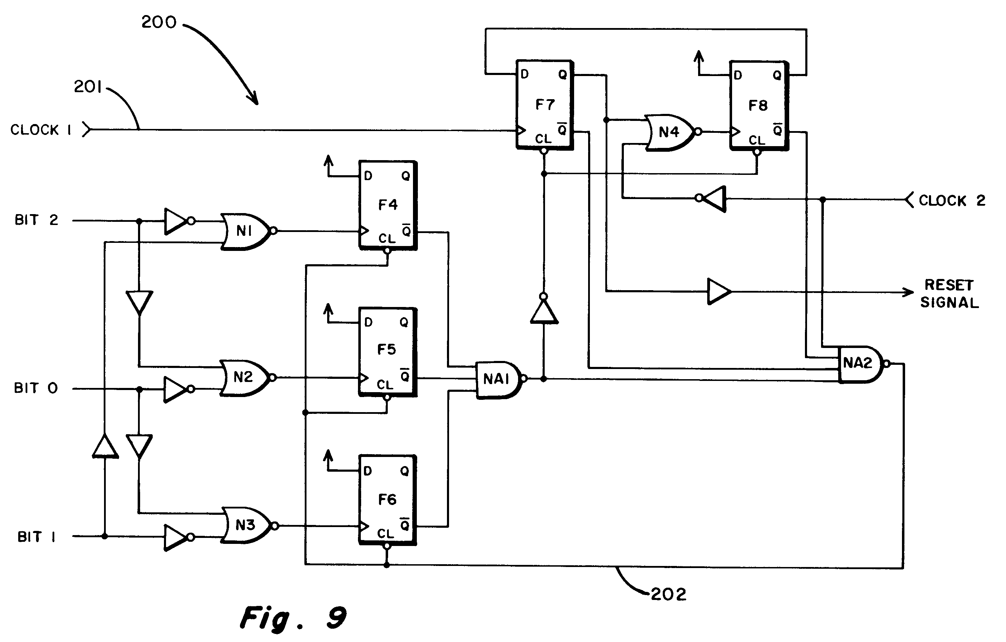

Note that in Figure 7, three "bit" signals, 0, 1 and 2 (square wave signals or digital "pulses") are shown in their radial relation to the signals A,B,C which occur at the same time and radial position. These bit signals 0, 1 and 2 can be found on output lines $B_0, B_1, B_2$ of the circuit 100 respectively. The negative going slope of each one of these three signals produces a reset signal of a finite duration. This is preferably accomplished with a microprocessor decode circuit of the three bit signals or, if only generating reset signals during "head-in" (i.e. the head moving towards the centre of the disk) is acceptable, two EXCLUSIVE-OR gates such as gates 52,53 arranged and connected as shown can be used. A preferred decode circuit is explained with reference to Figure 9, which generates a reset signal during rapid transition periods in the servo position error signal, but other constructions to accomplish this are possible. The bit signals used to generate the reset signal are produced by the circuit 100 which acts in the following manner.

The three phase signals A,B,C are compared by three comparators $U8_1, U8_2, U8_3$. Where the signal A on the line 31 is of higher voltage than the signal B on the line 32, the output of a non-inverting buffer circuit $U2_1$ is "high" and the output of an inverting circuit $U1_1$ is "low". Otherwise, the reverse is the case. The two other comparators $U8_2, U8_3$ and their associated inverting circuits $U1_2, U1_3$ and non-inverting buffer circuits $U2_2, U2_3$ function in the same way for their inputs.

The signals A,B,C are input into the circuit 100 on lines 31, 32 and 33 respectively. In Figure 7 typical signals A, B and C are shown with respect to a reference voltage level $V_{REF}$. The signals A,B,C are fed into the positive input of a respective one of the comparators $U8_1, U8_2, U8_3$. One of the other of the three signals A,B,C is input into the negative input of the comparators. "LM339" is the industry standard numerical designation for comparators used in a preferred embodiment and they are currently available from National Semiconductor Corporation.

Each one of the signals A,B,C is also input to two of six analog switches $U14_{(1-6)}$ to be passed through to inverting and non-inverting differential amplifier input lines 34,35, respectively, to create the servo position error signal SPE on line 36 as shown in Figures 7 and 8.

The signals A, B and C input to the comparators $U8_1, U8_2, U8_3$ in turn drive the inverting circuits $U1_1, U1_2, U1_3$, and also drive the non-inverting buffer circuits $U2_1, U2_2, U2_3$. The output of these circuits provide the proper switching of the analog switches U14$_{(1-6)}$.

Resistance/capacitor pairs 101,102,103 provide hysteresis to the respective comparators U8$_1$,U8$_2$,U8$_3$ to prevent multiple switching during noise transients which may appear in the signals A,B,C.

A differential amplifier U19 produces a signal on the line 36 as shown in Figure 8. The alphanumeric indicators attached to the signal shown in Figure 8 (for "head-in" sequence) correspond to the decimal or SPE indicators shown in Figure 7.

The bit signals of the comparators produced on the output lines B1,B2,B0, are shown in Figure 7 as 0, 1 and 2. Therefore, looking at the signals in a "head-in" direction in Figure 7, because the transition or unwanted signal portion occurs between areas designated 6 and 2, areas designated 3 and 1 and areas designated 5 and 4 (see Figure 5 and bottom of Figure 7) and because a downward going pulse occurs at each one of these area interfaces and because only one of the three bit signals is "high" at a downward going signal area, all that is necessary is to fire a reset signal at a downward going pulse. In a "head-out" direction each upward going pulse will signal that a reset signal is necessary; i.e., that the slope transition occurs at that interface. A microprocessor could receive these digital bit signals as input and based on a program generate a reset pulse at the proper upward or downward going transitions of each of the bit signals. It is simplest and most efficient to think of this in terms of the two EXCLUSIVE-OR gates 52,53 which will provide an output pulse of relatively short duration in conjunction with a digital one shot for each of the indicated transistors.

The decode of the bit signals 0,1,2 is accomplished with the equivalent of three AND gates with an output each to one of three flip-flops whose outputs are OR'd together. The output of this OR would be the reset signal for both "head-in" and "head-out" orientations. In practice the reset signal generation is more complicated and is explained with reference to Figure 9, where a circuit 200 to accomplish this is shown. However, it should be noted that other decode schemes are possible and that reset signals may come from signals other than the tri-phase servo signals of this embodiment.

In Figure 9, a clock input, which is a period length smaller than the desired duration of the reset signal, is provided to the circuit 200 at an input 201. The clock pulse should be a short portion of the clock period. The clock pulse (clock 1 in Figure 10) is provided as the clock input to a flip-flop F7. A second clock (clock 2 in Figure 10) provides a delayed clock to a NAND gate NA2, and its inverse is provided to a NOR gate N4. The Q output of the flip-flop F7 when "low" provides the reset signal used in the circuits 10 and 10A to control the switch SW.

The circuit 200 receives the three bit signals from the circuit 100 of Figure 6 (shown in time relation to each other in Figure 7) as inputs. They are provided, inverted and non-inverted as input to NOR gates N1,N2,N3 respectively. The outputs of these NOR gates are input to respective flip-flops F4,F5,F6. The $\overline{Q}$ output of these flip-flops is input to NAND gate NA1 whose output is provided as an input to the NAND gate NA2. The output of the NAND gate NA1 clears the flip-flop F7. The NAND gate NA2 also receives the Q outputs of the flip-flops F7,F8 as inputs. The output of the NAND gate NA2 provides a clear signal to the flip-flops F4,F5,F6. The D inputs of the flip-flops F4,F5,F6,F8 are all tied to "high" signal or voltage level as indicated by arrows.

It should be clear that the circuit 200 of Figure 9 and its associated timing diagram of Figure 10 is only one possibility for providing efficient decode for the reset signal.

## Claims

1. A circuit for removing unwanted temporal portions of a voltage varying signal on the occurrence of a reset signal and for differentiating a resultant corrected signal with the respect to a reference voltage, said circuit having switch means (SW) responsive to said reset signal applied to a first input; first operational amplifier means (U1-B) having positive and negative inputs and an output connected to a second input of said switch means (SW); second operational amplifier means (U1-A); storage capacitor means (C5) having one side connected to a reference voltage and having its other side in electrical connection to the negative input of the first operational amplifier means (U1-B) and a first output of the switch means (SW), said circuit being characterised by input capacitor means (C1) for receiving said input signal, the positive input of the first operational amplifier means (U1-B) being connected to receive a voltage representative of the current through said input capacitor means (C1); by said switch means (SW), in operation, being responsive to said reset signal to direct a second input of the switch means (SW) to a second output from a first output and thence to return said second input to said first output; by inverting amplifier means (U2) connected to receive the second output of the switch means (SW); and by the second operational amplifier means (U1-A) being arranged so as to receive said corrected signal from the inverting amplifier means (U2) and having a negative input which is connected through a first resistor (R3) and through the inverting amplifier means (U2) to said second output of the switch means, said negative input also being in electrical connection through said first resistor (R3) with said input capacitor means (C1) and with said positive input of said first operational amplifier means (U1-B), a positive input connected to a reference voltage, and providing a differentiated corrected signal at its output which is connected via a feedback resistor (R4) to said negative input.

2. A circuit as claimed in claim 1 characterised in that the negative input of said second operational amplifier means (U1-A) is also connected to a reference voltage through the first resistor (R3) and a filter capacitor (C2) which is connected between a second resistor (R2) and said first resistor, the negative input of said second operational amplifier means being in electrical connection through both said first and second resistors (R2,R3) to said input capacitor means (C1), to the output of said inverting amplifier means (U2) and to said positive input of said first operational amplifier means (U1-B).

3. A circuit as claimed in claim 1 or 2 characterised in that the negative input of said second operational amplifier means (U1-A) is in electrical connection with its output via said feedback resistor (R4) and a compensating capacitor (C3) connected in parallel therewith.

4. A circuit as claimed in claim 2 or 3 characterised in that a third resistor (R1) is connected between said second resistor (R2) and said input capacitor means (C1), said input capacitor means being connected through said third resistor (R1) with said inverting amplifier means (U2) and with said positive input of the first operational amplifier means (U1-B).

5. A circuit as claimed in any preceding claim characterised in that said reset signal is generated from a tri-phase servo signal.

6. A circuit as claimed in claim 5 characterised in that said reset signal is generated from the same tri-phase servo signal which is used to generate said input signal.

7. A circuit as claimed in any preceding claim characterised in that a storage resistor (R5) is connected in series between said storage capacitor means (C5) and said negative input of said first operational amplifier means (U1-B).

8. A circuit as claimed in claim 7 characterised in that one side of the storage resistor (R5) is connected to said first output of the switch means (SW) and said negative input of the first operational amplifier means (U1-B) and the other side is connected to said storage capacitor means (C5).

**Patentansprüche**

1. Schaltung zur Unterdrückung unerwünschter zeitlicher Abschnitte eines variablen Spannungssignals bei Auftreten eines Rücksetzsignals und zur Differenzierung eines resultierenden korrigierten Signals bezüglich einer Bezugsspannung, wobei die Schaltung auf ein einem ersten Eingang zugeführtes Rücksetzsignal ansprechende Schaltereinrichtungen (SW), ein erstes Operationsverstärkerelement (U1-B) mit positiven und negativen Eingängen und einem mit einem zweiten Eingang der Schaltereinrichtungen (SW) verbundenen Ausgang, ein zweites Operationsverstärkerelement (U1-A) und ein Speicherkondensatorelement (C5) aufweist, dessen einer Anschluß mit einer Bezugsspannung verbunden ist und dessen anderer Anschluß in elektrischer Verbindung mit dem negativen Eingang des ersten Operationsverstärkerelementes (U1-B) und einem ersten Ausgang der Schaltereinrichtungen (SW) steht, und wobei die Schaltung dadurch gekennzeichnet ist, daß ein Eingangskondensatorelement (C1) zum Empfang des Eingangssignals vorgesehen ist, daß der positive Eingang des ersten Operationsverstärkerelementes (U1-B) zum Empfang einer den Strom durch das Eingangskondensatorelement (C1) darstellenden Spannung angeschaltet ist, daß die Schaltereinrichtungen (SW) im Betrieb auf das Rücksetzsignal ansprechen, um einen zweiten Eingang der Schaltereinrichtungen (SW) von einem ersten Ausgang auf einen zweiten Ausgang zu überführen und dann den zweiten Eingang an den ersten Ausgang zurückzuleiten, daß ein invertierendes Verstärkerelement (U2) zum Empfang des zweiten Ausgangs der Schaltereinrichtungen (SW) angeschaltet ist, und daß das zweite Operationsverstärkerelement (U1-A) derart angeordnet ist, daß es das korrigierte Signal von dem invertierenden Verstärkerelement (U2) empfängt und einen negativen Eingang, der über einen ersten Widerstand (R3) und über das invertierende Verstärkerelement (U2) mit dem zweiten Ausgang der Schaltereinrichtungen verbunden ist, wobei der negative Eingang weiterhin über den ersten Widerstand (R3) mit dem Eingangskondensatorelement (C1) und mit dem positiven Eingang des ersten Operationsverstärkerelementes (U1-B) in elektrischer Verbindung steht, und einen positiven, mit einer Bezugsspannung verbundenen Eingang aufweist und ein differenziertes korrigiertes Signal an seinem Ausgang liefert, der über einen Rückführungswiderstand (R4) mit dem negativen Eingang verbunden ist.

2. Schaltung nach Anspruch 1,
dadurch gekennzeichnet, daß der negative Eingang des zweiten Operationsverstärkerelementes (U1-A) außerdem mit einer Bezugsspannung über den ersten Widerstand (R3) und einen Filterkondensator (C2) verbunden ist, der zwischen einem zweiten Widerstand (R2) und dem ersten Widerstand angeschaltet ist, und daß der negative Eingang des zweiten Operationsverstärkerelementes über beide der ersten und zweiten Widerstände mit dem Eingangskondensatorelement (C2), mit dem Ausgang des invertierenden Verstärkerelementes (U2) und mit dem positiven Eingang des ersten Operationsverstärkerelementes (U1-B) in elektrischer Verbindung steht.

3. Schaltung nach Anspruch 1 oder 2,
dadurch gekennzeichnet, daß der negative Eingang des zweiten Operationsverstärkerelementes (U1-A) mit seinem Ausgang über den Rückführungswiderstand (R4) und einen parallel hierzu geschalteten Kompensationskondensator (C3) in elektrischer Verbindung steht.

4. Schaltung nach Anspruch 2 oder 3,
dadurch gekennzeichnet, daß ein dritter Widerstand (R1) zwischen dem zweiten Widerstand (R2) und dem Eingangskondensatorelement (C1) eingeschaltet ist, und daß das Eingangskondensatorelement über den dritten Widerstand (R1) mit dem invertierenden Verstärkerelement (U2) und mit dem positiven Eingang des ersten Operationsverstärkerelementes (U1-B) verbunden ist.

5. Schaltung nach einem der vorhergehenden Ansprüche,
dadurch gekennzeichnet, daß das Rücksetzsignal aus einem Dreiphasen-Servosignal erzeugt wird.

6. Schaltung nach Anspruch 5,
dadurch gekennzeichnet, daß das Rücksetzsignal aus dem gleichen Dreiphasen-Servosignal erzeugt wird, das zur Erzeugung des Eingangssignals verwendet wird.

7. Schaltung nach einem der vorhergehenden Ansprüche,
dadurch gekennzeichnet, daß ein Speicherwiderstand (R5) in Serie zwischen dem Speicherkondensatorelement (C5) und dem negativen Eingang des ersten Operationsverstärkerelementes (U1-B) eingeschaltet ist.

8. Schaltung nach Anspruch 7,
dadurch gekennzeichnet, daß ein Anschluß des Speicherwiderstandes (R5) mit dem ersten Ausgang der Schaltereinrichtungen (SW) und dem negativen Eingang des ersten Operationsverstärkerelementes (U1-B) verbunden ist, während der andere Anschluß mit dem Speicherkondensatorelement (C5) verbunden ist.

**Revendications**

1. Circuit destiné à éliminer les parties temporelles indésirables d'un signal de tension variable en réponse à un signal de remise à zéro et destiné à différencier un signal corrigé résultant par rapport à une tension de référence, ledit circuit possédant un moyen commutateur (SW) qui répond audit signal de remise à zéro appliqué à une première entrée ; un premier moyen amplificateur opérationnel (U1-B) possédant des entrées positive et négative et une sortie connectée à une seconde entrée dudit moyen commutateur (SW) ; un second moyen amplificateur opérationnel (U1-A) ; un moyen condensateur de stockage (C5) ayant un côté connecté à une tension de référence et son autre côté connecté électriquement à l'entrée négative du premier moyen amplificateur opérationnel (U1-B) et à une première sortie du moyen commutateur (SW), ledit circuit étant caractérisé en ce qu'il comprend un moyen condensateur d'entrée (C1) destiné à recevoir ledit signal d'entrée, l'entrée positive du premier moyen amplificateur opérationnel (U1-B) étant connectée pour recevoir une tension représentative du courant qui traverse ledit moyen condensateur d'entrée (C1) ; en ce que ledit moyen commutateur (SW) répond, en fonctionnement, audit signal de remise à zéro en dirigeant une seconde entrée du moyen commutateur (SW) à une seconde sortie issue d'une première sortie, et en renvoyant de là, ladite seconde entrée à ladite première sortie ; en ce qu'il comprend un moyen amplificateur inverseur (U2) connecté pour recevoir la seconde sortie du moyen commutateur (SW) ; et en ce que le second moyen amplificateur opérationnel (U1-A) est agencé de manière à recevoir ledit signal corrigé issu du moyen amplificateur inverseur (U2) et possède une entrée négative qui est connectée à la seconde sortie du moyen commutateur à travers une première résistance (R3) et à travers le moyen amplificateur inverseur (U2), ladite entrée négative étant aussi connectée électriquement, à travers ladite première résistance (R3) audit moyen condensateur d'entrée (C1) et à ladite entrée positive dudit premier moyen amplificateur opérationnel (U1-B), une entrée positive connectée à une tension de référence, et qui fournit un signal corrigé différencié à sa sortie qui est connectée à ladite entrée négative par l'intermédiaire d'une résistance de réaction (R4).

2. Circuit selon la revendication 1, caractérisé en ce que l'entrée négative dudit second moyen amplificateur opérationnel (U1-A) est aussi connectée à une tension de référence à travers la première résistance (R3) et un condensateur de filtrage (C2) qui est connecté entre une seconde résistance (R2) et ladite première résistance, l'entrée négative dudit second moyen amplificateur opérationnel étant connectée électriquement, à travers lesdites première et seconde résistances (R2,R3) audit moyen condensateur d'entrée (C1), à la sortie dudit moyen amplificateur inverseur (U2) et à ladite entrée positive dudit premier moyen amplificateur opérationnel (U1-B).

3. Circuit selon la revendication 1 ou 2, caractérisé en ce que l'entrée négative dudit second moyen amplificateur opérationnel (U1-A) est connectée électriquement à sa sortie à travers ladite résistance de réaction (R4) et un condensateur de compensation (C3) connecté en parallèle avec cette dernière.

4. Circuit selon la revendication 2 ou 3, caractérisé en ce qu'une troisième résistance (R1) est connectée entre ladite seconde résistance (R2) et ledit moyen condensateur d'entrée (C1), ledit moyen condensateur d'entrée étant connecté à travers ladite troisième résistance (R1) audit moyen amplificateur inverseur (U2) et à ladite entrée positive du premier moyen amplificateur opérationnel (U1-B).

5. Circuit selon l'une quelconque des revendications précédentes, caractérisé en ce que ledit signal de remise à zéro est engendré à partir d'un servo-signal triphasé.

6. Circuit selon la revendication 5, caractérisé en ce que ledit signal de remise à zéro est engendré à partir du même servo-signal triphasé que celui qui est utilisé pour engendrer ledit signal d'entrée.

7. Circuit selon l'une quelconque des revendications précédentes, caractérisé en ce qu'une résistance de stockage (R5) est connectée en série entre ledit moyen condensateur de stockage (C5) et ladite entrée négative dudit premier moyen amplificateur opérationnel (U1-B).

8. Circuit selon la revendication 7, caractérisé en ce qu'un côté de la résistance de stockage (R5) est connecté à ladite première sortie du moyen commutateur (SW) et à ladite entrée négative du premier moyen amplificateur opérationnel (U1-B) et que l'autre côté est connecté audit moyen condensateur de stockage (C5).

Fig. 1

Fig. IA

*Fig. 2*

EP 0 279 993 B1

Fig. 3

Fig. 4

Fig. 5

D,U,T SEQUENCE (HEAD-OUT) ⟶

T,U,D SEQUENCE (HEAD-IN) ⟵

Fig. 8

12

Fig. 6

EP 0 279 993 B1

Fig. 7

HEAD-OUT →
HEAD-IN ←

| BIT | | | | | | | | |
|---|---|---|---|---|---|---|---|---|
| 0 | ØA > ØB | | | | | | | |
| 1 | ØB > ØC | | | | | | | |
| 2 | ØC > ØA | | | | | | | |
| | DECODE AREA CORESPONDANT | 4 | 6 | 2 | 3 | 1 | 5 | 4 |
| | SPE | C−B | | B−A | | A−C | | |

CLOCK 1

CLOCK 2

F4, F5, or F6

F7         RESET SIGNAL

F8

Fig. 10

EP 0 279 993 B1

Fig. 9